# EUROPEAN PATENT APPLICATION

(11) **EP 1 615 008 A2**
(43) Date of publication of application: **11.01.2006**
(21) Application number: 05105482.3
(22) Date of filing: 21.06.2005
(51) Int. Cl.: G01J 1/00

(54) **Diamond sensor**

(30) Priority: 05.07.2004 JP 2004198319
(71) Applicant: KABUSHIKI KAISHA KOBE SEIKO SHO, Kobe-shi, Hyogo 651-8585 (JP)
(72) Inventor: HAYASHI, Kazushi, 651-2271, Kobe-shi (JP); TACHIBANA, Takeshi, 651-2271, Kobe-shi (JP); KAWAKAMI, Nobuyuki, 651-2271, Kobe-shi (JP); YOKOTA, Yoshihiro, 651-2271, Kobe-shi (JP)
(74) Representative: Bailey, David Martin

(57) **Abstract**

A diamond element is mounted on an insulating base material having a thickness of not more than 3 mm provided with one pair of metal interconnects. In the diamond element, an insulating diamond layer to act as a detection layer is deposited on a substrate, and one pair of interdigitated electrodes are deposited on the surface of this insulating diamond layer. The interdegital electrodes of the diamond element are connected via wires to the metal interconnects deposited on the insulating base material. The insulating base material may transmit ultraviolet radiation to be detected. The diamond sensor is capable of stably detecting ultraviolet radiation even when the distance between a lamp and an irradiation object is short.

## Description

### BACKGROUND OF THE INVENTION

### 1. Field of the Invention

The present invention relates to a diamond sensor to measure short-wavelength radiation, e.g., vacuum ultraviolet radiation, and a method for manufacturing the same. In particular, the present invention relates to a low-profile, flat diamond sensor suitable for a cleaning apparatus to perform ultraviolet irradiation in the air, as well as a method for manufacturing the same.

### 2. Description of the Related Art

In general, when ultraviolet radiation or the like having a wavelength shorter than visible light is observed, the sunlight or other light often becomes a cause of uncertainty. Therefore, a solar insensitive property is desirable. Furthermore, since the energy of the radiation in the ultraviolet region is high, the high durability is required to perform stable observation with good reproducibility over an extended period of time.

Therefore, an ultraviolet sensor including a diamond thin film has been proposed recently (refer to "Diamond Photodetectors for next generation 157-nm deep-UV photolithography tools", Diamond and Related Materials, 2001, Vol. 10, p. 693-697, and "Development of Ultraviolet Sensors Using Highly-oriented Diamond Films", R&D KOBE STEEL ENGINEERING REPORTS Vol. 52, No. 2, pp. 23-26, for example). The diamond thin film can be used at high temperature and exhibits excellent durability, and has properties of a semiconductor with a wide band gap. Consequently, a highly reliable sensor can be realized at low cost. A semiconductor sensor including this diamond thin film exhibits excellent durability as compared with a known sensor element in which silicon or the like with a narrow band gap and a wavelength filter are combined. In addition, there are advantages that miniaturization and weight reduction can be achieved and a complicated circuit configuration is unnecessary as compared with a known sensor including a photo cathode tube or the like.

In a known diamond sensor, a diamond thin film produced by vapor phase synthesis is used as a detection layer and, for example, a pair of electrodes is fabricated on the surface of this diamond thin film. In the diamond sensor having such a coplanar structure, electron-hole pairs are generated in the diamond thin film when light is applied. These electron-hole pairs are collected at each electrode by applying a bias voltage between a pair of electrodes, and are detected as electric signals. The diamond sensor having such a configuration is generally referred to as a photoconductor, and has an insulating property when radiation is not applied. However, the photoconductor is changed to have an electrically conductive property when radiation is applied.

As is described in the prior art documents, the diamond sensor is usually packaged in an industrial hermetic seal, e.g., TO-5, such that the sensor surface is not contaminated with dust and organic materials in a measurement atmosphere. The sensor package is sealed, and the inside thereof is purged with an inert gas, e.g., nitrogen, so that the influence by gas species is reduced.

An intense low-pressure mercury lamp has been previously used in removal of organic materials on the surface of a glass substrate or the like and cleaning, while the lamp emits ultraviolet radiation of 254 nm or ultraviolet radiation of 185 nm and 254 nm and, therefore, generates ozone at high efficiency. The diamond sensor is most suitable for use in measurement of the intensity of radiation applied from such an apparatus, and is used in quality control and the like. For example, the diamond sensor is set on a belt conveyer to carry glass, and the intensity of ultraviolet radiation can be measured by carrying the diamond sensor immediately below the lamp.

However, the above-described known technologies include the following problems. Recently, the dimensions of substrates used for liquid crystal display have been increased. When a low-pressure mercury lamp, which also emits light, e.g., visible light, simultaneously in addition to the ultraviolet radiation, is applied to this large glass substrate, a thermal stress is generated in the glass substrate. Consequently, damage resulting from strain and/or warp occurs, so that the yield is decreased. In order to protect the glass substrate from damage, a study to use an excimer lamp having its center wavelength at 172 nm has been started. This excimer lamp has an emission spectrum only in the ultraviolet region and, therefore, the above-described problem does not occur. However, since the radiation is absorbed by oxygen in the air, the intensity of the radiation is attenuated rapidly in the atmosphere. Consequently, the distance between a lamp house and a substrate must be as close as possible when the excimer lamp is used.

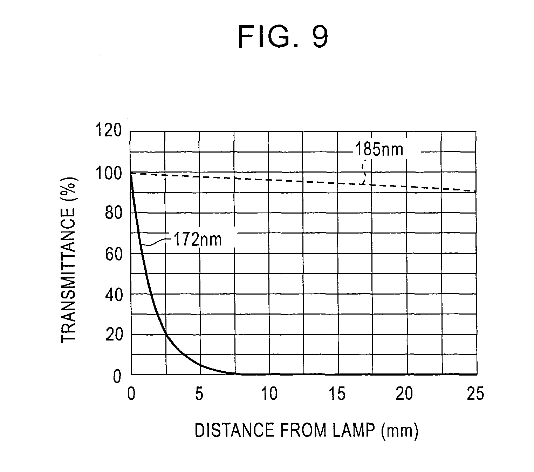

Fig. 9 is a graph showing the relationship between the transmittance of ultraviolet radiation with a wavelength of 172 nm or 185 nm and the irradiation distance, where the horizontal axis indicates the distance from the lamp and the vertical axis indicates the transmittance of the ultraviolet radiation in the air. When the excimer lamp with a wavelength of 172 nm is used, adequate irradiation intensity cannot be attained unless the spacing between the lamp house and the glass substrate is 5 mm or less, and desirably is 2 mm or less. Consequently, there is a problem in that the above-described known diamond sensor cannot be applied to such a measurement because of the thickness thereof. Furthermore, in such a measurement in which sharp attenuation occurs with an increase in irradiation distance, the quantity and intensity of irradiation must be measured at a position as close to the glass surface as possible. However, a sensor configured to be enclosed in a package, as in the known diamond sensor, has a problem in that it is difficult to perform a measurement at such a position.

### SUMMARY OF THE INVENTION

The present invention was made in consideration of the above-described problems. Accordingly, the present invention is directed to provide a diamond sensor capable of stably detecting ultraviolet radiation even when the distance between a lamp and an irradiation object is small, as well as a method for manufacturing the same.

A diamond sensor according to the present invention comprises an insulating base material having a thickness of not more than 3 mm; at least one pair of metal interconnects selectively deposited or fabricated on the insulating base material; and a diamond element which comprises a diamond layer to act as a detection layer and at least one pair of surface electrodes deposited or fabricated on the diamond layer, wherein the surface electrodes in the pair are connected to their respective metal interconnects in the pair.

In the present invention, the diamond element is mounted on the very thin insulating base material, e.g., a glass or quartz substrate, provided with metal interconnects, and the above-described metal interconnects are connected to their respective surface electrodes of the diamond element. Therefore, the measurement object radiation, e.g., ultraviolet radiation, can be stably detected even when the distance between a lamp and an irradiation object is short, that is, a gap through which the sensor passes is narrow.

Especially in the present invention, since the thickness of the insulating base material is not more than 3 mm, a sensor capable of detecting ultraviolet radiation with a wavelength of 172 nm is easily realized. More preferably, the thickness of the insulating base material is not more than 1 mm.

The diamond sensor may further comprise an element substrate and the diamond layer may be deposited on the element substrate. In this construction, the insulating base material may transmit a measurement object radiation and the diamond layer may face the insulating base material to detect the radiation.

In the diamond sensor according to the present invention, the diamond layer may be provided directly on the insulating base material.

Alternatively, surface electrodes may face the insulating base material and the diamond layer may be positioned on the outer side of the surface electrodes.

In the case of a diamond sensor without an element substrate, the low-profile diamond element is mounted on the insulating base material, e.g., a glass substrate, provided with metal interconnects, and the above-described metal interconnects are connected to their respective surface electrodes of the diamond element. Therefore, the thickness can be reduced by the thickness of the element substrate, for example, by about 0.5 mm in the case of a silicon substrate, as compared with a known diamond sensor. Consequently, the measurement object radiation, e.g., ultraviolet radiation, can be stably detected even when a gap through which the sensor passes is narrow, whereas it is difficult to detect with a known diamond element.

The above-described insulating base material may be formed from a material which transmits the measurement object radiation, the above-described diamond element may be fabricated while the surface provided with the above-described surface electrodes is arranged to face the above-described insulating base material side, and the measurement object radiation may be applied from the above-described insulating base material side. In this manner, the diamond element and the metal interconnects are not directly irradiated with the measurement radiation and, therefore, damage resulting from accidental contact or the like can be prevented.

In the case of a diamond sensor without an element substrate, the above-described insulating base material may be formed from a material which transmits the measurement object radiation, and the measurement object radiation may be applied from the above-described insulating base material side. Alternatively, the above-described diamond element may be fabricated while the surface provided with the above-described surface electrodes may be arranged to face the above-described insulating base material side, and the above-described measurement object radiation may be passed through the above-described insulating base material and be incident on the surface provided with the above-described surface electrodes in the above-described diamond sensor. Alternatively, the above-described diamond element may be fabricated while the surface opposite to the surface provided with the above-described surface electrodes may be arranged to face the above-described insulating base material side, and the above-described measurement object radiation may be passed through the above-described insulating base material and be incident on the surface opposite to the surface provided with the above-described surface electrodes in the above-described diamond sensor. In this manner, the diamond element and the metal interconnects are not directly irradiated with the measurement radiation and, therefore, damage resulting from accidental contact or the like can be prevented, so that the durability is improved. In addition, when the measurement object radiation is made to be incident on the surface opposite to the surface provided with the surface electrodes, the measurement object radiation is not obstructed by the surface electrodes, so that the incident angle characteristic is improved.

Alternatively, the above-described diamond element may be fabricated while the surface provided with the above-described surface electrodes is arranged to face the above-described insulating base material side, and the above-described measurement object radiation may be applied from the diamond element side. In this manner, the measurement object radiation is not obstructed by the surface electrodes, so that the incident angle characteristic is improved.

A concave portion may be formed beforehand in a region to be provided with the diamond element on the surface of the insulating base material, and the diamond element may be fabricated in this concave portion. Consequently, the surface of the diamond element and the surface of the base material become flush with each other, so that accidental contact can be prevented.

A diamond layer in the present invention may be formed from, for example, a polycrystalline diamond produced by vapor phase synthesis. The above-described diamond layer may be, for example, a highly-oriented diamond layer in which the surface is composed of the (100) crystal plane, grown crystal grains are uniaxially oriented relative to the above-described substrate surface, and the crystal plane is also oriented in-plane. The highly-oriented diamond layer refers to a layer in which both the growth direction and the in-plane direction of crystal grain in a polycrystalline diamond are oriented in one direction relative to the substrate surface. The surface thereof takes on a specific surface geometry in which flat (001) facets are aligned. Consequently, the crystal defect density in the vicinity of the surface of this film is smaller than that of a general polycrystalline film, and the carrier mobility becomes an order of magnitude larger. Therefore, the detection performance is improved as compared with that of the known diamond sensor.

A diamond sensor according to the present invention can detect ultraviolet radiation, for example.

In a diamond sensor according to the present invention, the insulating base material preferably transmits ultraviolet radiation with a wavelength of 172nm.

A method for manufacturing a diamond sensor according to the present invention is characterized by including the steps of selectively forming at least one pair of metal interconnects on an insulating base material; forming a diamond layer to act as a detection layer on an element substrate and forming at least one pair of surface electrodes on this diamond layer, so as to produce a diamond element; and fabricating the above-described diamond element on the above-described insulating substrate and connecting the surface electrodes in the above-described pair to their respective metal interconnects in the above-described pair.

In the present aspect of the invention, the metal interconnects are formed on the insulating base material, e.g., a glass substrate, and in addition, the diamond element is mounted on this insulating base material, and the above-described metal interconnects are connected to their respective surface electrodes of the diamond element. Consequently, a diamond sensor applicable even in the case where a gap, through which the sensor passes, is narrow can readily be produced.

The above-described insulating base material may be formed from a material which transmits the measurement object radiation, e.g. diffused silica, quartz and sapphire, and the above-described diamond element may be fabricated while the surface provided with the above-described surface electrodes is arranged to face the above-described insulating base material side.

The above-described diamond element may be fabricated while the surface provided with the above-described surface electrodes is arranged to face the above-described insulating base material side, the surface electrodes in the above-described pair may be connected to their respective metal interconnects in the above-described pair and, thereafter, the above-described element substrate may be removed by dissolution. In this manner, the thickness of the sensor can be further reduced. Since the element substrate is removed after the diamond element is mounted on the insulating base material, the thickness can be reduced without damaging the diamond layer to act as a detection layer.

Another method for manufacturing a diamond sensor according to the present invention is characterized by including the steps of selectively forming at least one pair of metal interconnects on an insulating base material; removing the above-described element substrate by dissolution after forming a diamond layer to act as a detection layer on an element substrate and forming at least one pair of surface electrodes on the diamond layer, so as to produce a diamond element; and disposing the above-described diamond element on the above-described insulating base material and connecting the surface electrodes in the above-described pair to their respective metal interconnects in the above-described pair.

In the present aspect of the invention, since the diamond element from which the element substrate has been removed is mounted on the insulating base material, the thickness of the sensor can be further reduced. Furthermore, since the element substrate is removed in advance of the mounting on insulating base material, the insulating base material is not brought into contact with any chemical solution. As a result, the range of choices in insulating base materials is extended.

The above-described insulating base material may be formed from a material which transmits the measurement object radiation. In this manner, the measurement object radiation can be applied from the insulating base material side and, therefore, the durability is improved. The above-described diamond element may be fabricated while the surface provided with the above-described surface electrodes is arranged to face the above-described insulating base material side. Alternatively, the above-described diamond element may be fabricated while the surface opposite to the surface provided with the above-described surface electrodes is arranged to face the above-described insulating base material side.

Furthermore, the above-described diamond layer may be formed by a vapor phase synthesis method. In this manner, the detection performance is improved as compared with that of the known diamond sensor. In the above-described method for manufacturing a diamond sensor, a concave portion having a depth on the order of the thickness of the diamond element may be formed beforehand in a region to be provided with the diamond element on the surface of the above-described insulating base material, and the diamond element may be fabricated in this concave portion. Consequently, the surface of the diamond element and the surface of the base material become flush with each other, so that accidental contact can be prevented.

According to the present invention, the diamond element provided with the detection layer is deposited on the insulating base material provided with the metal electrodes, and the surface electrodes of the diamond element are connected to their respective interconnects on the insulating base material. Consequently, ultraviolet radiation can be stably detected even in a narrow gap at which any measurement cannot be performed with known sensors.

### BRIEF DESCRIPTION OF THE DRAWINGS

Fig. 1 is a plan view of the diamond sensor according to the first embodiment of the present invention.
Fig. 2 is a side view schematically showing the diamond sensor according to the first embodiment of the present invention.
Fig. 3 is a side view schematically showing the diamond sensor according to the second embodiment of the present invention.
Fig. 4 is a plan view of the diamond sensor according to the second embodiment of the present invention, viewed from the insulating base material side.
Fig. 5 is a side view schematically showing the diamond sensor according to the third embodiment of the present invention.
Fig. 6 is a side view schematically showing the diamond sensor according to the modified example of the third embodiment of the present invention.
Fig. 7 is a side view schematically showing the diamond sensor according to the fourth embodiment of the present invention.
Fig. 8 is a block diagram showing the evaluation method of the ultra violet sensor according to Example 1 of the present invention.
Fig. 9 is a graph showing the relationship between the transmittance of radiation with a wavelength of 172 nm or 185 nm and the irradiation distance, where the horizontal axis indicates the irradiation distance and the vertical axis indicates the transmittance in the air.

### DESCRIPTION OF THE PREFERRED EMBODIMENTS

In order to achieve the above-described objects, the inventors of the present invention conducted intensive research. As a result, it was found out that when metal interconnects were selectively formed on the surface of a very thin insulating base material, e.g., glass substrate which was most frequently used as a treatment object, a diamond element provided with a detection layer was joined to this glass substrate, and electrodes of the element were connected to their respective electrodes on the insulating base material, ultraviolet radiation was able to be stably detected even in a narrow gap at which any measurement was previously unable to be performed.

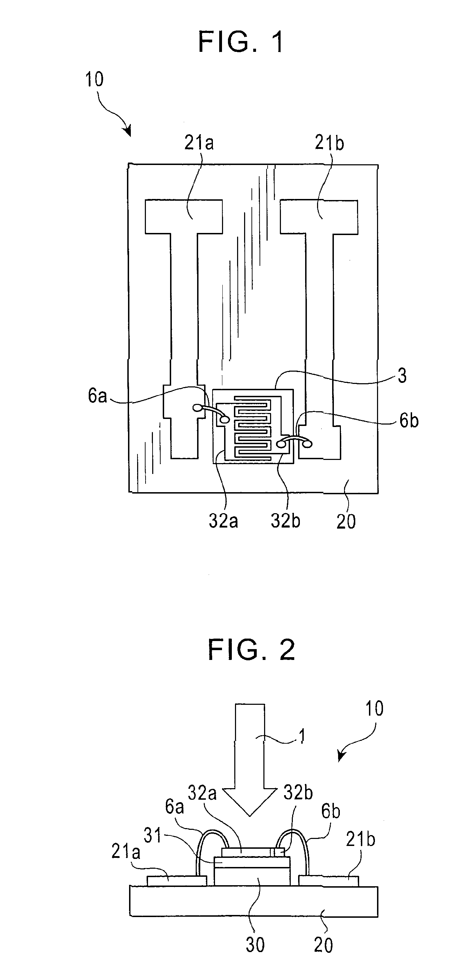

The diamond sensors according to the embodiments of the present invention will be specifically described below with reference to the attached drawings. A diamond sensor according to a first embodiment of the present invention will be described. Fig. 1 is a plan view of the diamond sensor according to the first embodiment of the present invention. Fig. 2 is a side view schematically showing this diamond sensor. As shown in Fig. 1 and Fig. 2, a diamond sensor 10 of the present embodiment is selectively provided with one pair of metal interconnects 21a and 21b on a tabular insulating base material 20. A diamond element 3 is mounted on the insulating base material 20. In the diamond element 3, an insulating diamond layer 31 to act as a detection layer is deposited on a substrate 30, and one pair of interdigitated electrodes 32a and 32b are deposited on the surface of this insulating diamond layer 31. The interdegital electrodes 32a and 32b of the diamond element 3 are electrically connected by wire bonding or the like to the metal interconnects 21a and 21b, respectively, deposited on the insulating base material 20. For example, gold wires or the like are used as wires 6a and 6b connecting the interdegital electrodes 32a and 32b and the metal interconnects 21a and 21b to each other.

The insulating base material 20 in the diamond sensor 10 of the present embodiment is not specifically limited as long as the base material is a tabular material made of, for example, glass, sapphire, or plastic, and has strength at some extent of level in consideration of the application of an ultraviolet lamp or the like. The insulating diamond layer 31 can be formed by a known method. In particular, a polycrystalline diamond film synthesized by a chemical vapor deposition (CVD) method is industrially preferable, wherein plasma is used in the CVD method, so that excellent controllability is utilized, and the diamond film can be stably produced at low cost. More preferably, the insulating diamond layer 31 is a highly-oriented diamond film in which the surface is composed of the (100) face of the diamond, and crystal grains are oriented in a constant direction. This highly-oriented diamond film is classified into a polycrystalline film in a broad sense. However, both the growth direction and the in-plane direction of crystal grain are oriented in a constant direction and the surface thereof takes on a specific surface geometry in which flat (001) facets are aligned, so that the crystal defect density in the vicinity of the surface is smaller than that of a general polycrystalline film. Consequently, the carrier mobility becomes an order of magnitude larger and, therefore, excellent detection characteristic is exhibited.

The metal electrodes 21a and 21b and the interdegital electrodes 32a and 32b may be formed from a general metal, e.g., gold, platinum, or aluminum. A known method, e.g., a vacuum evaporation method, a sputtering method, an ion plating method, or a CVD method, may be used as the forming method therefor. A known method can be applied to a method for selectively forming the metal interconnects on the insulating base material 20. However, a forming method by using photolithography is suitable. In this case, examples of applicable methods include a method in which a metal film is formed all over the insulating base material 21, a resist pattern is formed by photolithography in a region corresponding to an interconnect pattern on this metal film and, thereafter, the metal film is etched while this resist pattern is used as a mask, or a lift-off method in which a resist pattern is formed beforehand on the insulating base material 21 while the resist pattern is provided with openings in the region where the interconnects are to be formed, a metal film is formed while this resist pattern is used as a mask, and thereafter, the resist pattern is removed by dissolution to remove the unnecessary metal film.

In the diamond sensor 10 of the present embodiment, the interdigitated electrodes 32a and 32b are deposited on the surface of the insulating diamond layer 31. However, the present invention is not limited to this. It is essential only that at least one pair of electrodes is deposited on the surface of the insulating diamond layer 31. The shapes thereof are voluntarily determined. When the lengths of portions facing each other are increased in the shapes, the region subjected to detection of the ultraviolet radiation is increased and, therefore, high sensitivity can be attained. In particular, when the ultraviolet radiation is measured, it is more preferable to adopt an interdigitated structure in which, for example, the width is 1 to 50 µm and the spacing between electrodes is 1 to 50 µm.

The substrate 30 is not specifically limited. For example, when the insulating diamond layer 31 is formed from a highly-oriented diamond film, it is desirable to use a silicon substrate having the surface composed of the (001) face. Furthermore, various coatings may be applied to the surface of the diamond element in accordance with purposes. The diamond element 3 and the insulating base material 20 may be joined by, for example, adhesion through the use of a silver paste or an adhesive or low-temperature brazing through the use of Au-Sn or the like. In addition, fixing can also be performed by pressure bonding through the use of bumps or by applying a very small quantity of SOG (spin on glass: water glass), placing the element and, thereafter, performing sintering.

The operation of the diamond sensor 10 configured as described above according to the present embodiment will be described below. In the diamond sensor 10 of the present embodiment, the insulating diamond layer 31 serves as a detection layer, and a bias voltage is applied between the interdigitated electrode 32a and the interdigitated electrode 33b. When the radiation containing an ultraviolet, an X-ray, a soft X-ray, and the like and having energy at a level higher than the band gap of the diamond is incident on the insulating diamond layer 31 from the surface on the interdigitated electrodes 32a and 32b side, carriers (electrons and holes) are generated in the insulating diamond layer 31. These carriers are moved by an electric field generated by the bias voltage applied between the interdigitated electrode 32a and the interdigitated electrode 32b. The carriers are collected at the interdigitated electrode 32a or the interdigitated electrode 32b, and are output as electric signals through the metal electrodes 21a and 21b.

In the diamond sensor of the present embodiment, since the diamond element is mounted on the insulating base material provided with interconnects, the ultraviolet radiation can be stably detected even at a short distance from the irradiation lamp. Consequently, the practical range of the ultraviolet sensor including a low-cost highly-oriented diamond film and a polycrystalline diamond film is expanded. Therefore, a new application area can be developed and, in addition, a significant contribution can be made to the development of the industrial field in which the ultraviolet radiation, the vacuum ultraviolet radiation, and the deep ultraviolet radiation are used.

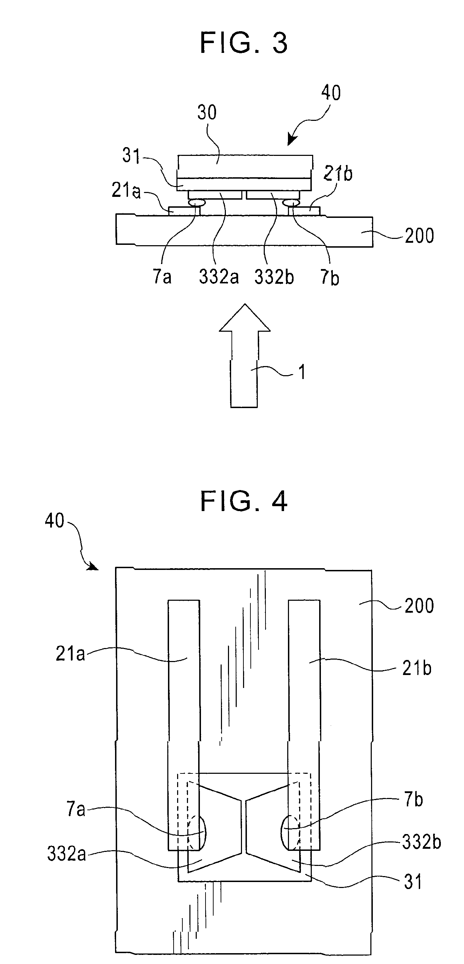

A diamond sensor according to the second embodiment of the present invention will be described below. Fig. 3 is a side view schematically showing a diamond sensor 40 of the present embodiment. Fig. 4 is a plan view of this diamond sensor viewed from an insulating base material side. In Fig. 3 and Fig. 4, the same constituents as those in the diamond sensor 10 of the first embodiment shown in Fig. 1 and Fig. 2 are indicated by the same reference numerals and detailed explanations thereof will not be provided. As shown in Fig. 3, the diamond sensor 40 of the present embodiment is selectively provided with one pair of metal interconnects 21a and 21b on an insulating base material 200 which transmits the measurement object radiation 1. In a diamond element, an insulating diamond layer 31 to act as a detection layer is deposited on a substrate 30, and one pair of trapezoid electrodes 332a and 332b in the shape of a trapezoid in a plan view are deposited on the surface of this insulating diamond layer 31. The diamond element is mounted on the insulating base material 200 such that the surface provided with the trapezoid electrodes 332a and 332b faces the insulating base material 200 side. In this diamond sensor 40, the trapezoid electrodes 332a and 332b are deposited on the metal interconnects 21a and 21b, respectively, and the trapezoid electrodes and the metal interconnects are connected to each other by, for example, a method in which gold bumps 7a and 7b are pressure-bonded.

It is essential only that the insulating base material 200 in the diamond sensor of the present embodiment is a tabular material made of a material which transmits the target ultraviolet radiation. For example, synthetic quartz glass, sapphire, magnesium fluoride, and calcium fluoride may be used.

In the diamond sensor 40 of the present embodiment, the measurement object radiation 1 is incident from the insulating base material 200 side. Consequently, since the diamond element and the metal interconnects 21a and 21b are not directly exposed to the ultraviolet radiation, the diamond element can be protected from dust, ozone, accidental contact, and the like and, therefore, the durability is improved. The configuration other than those described above, the operation, and the effect of the diamond sensor 40 of the present embodiment are similar to those of the diamond sensor 10 of the above-described first embodiment.

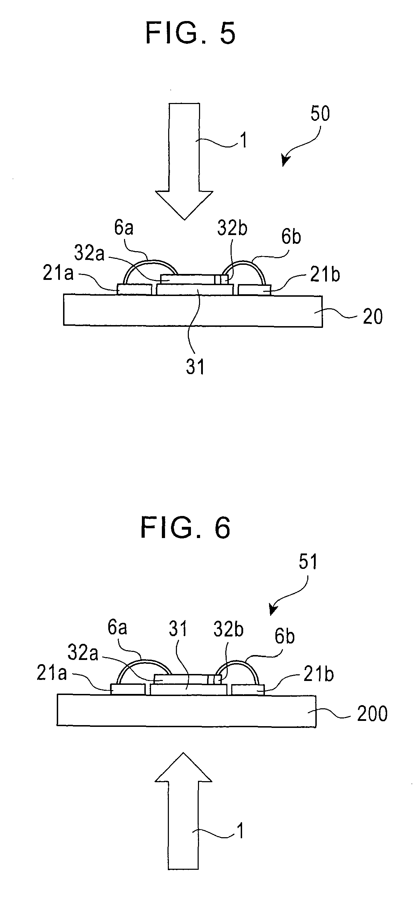

A diamond sensor according to the third embodiment of the present invention will be described below. Fig. 5 is a side view schematically showing a diamond sensor 50 of the third embodiment of the present invention. In Fig. 5, the same constituents as those in the diamond sensor 10 of the above-described first embodiment are indicated by the same reference numerals and detailed explanations thereof will not be provided. As shown in Fig. 5, the diamond sensor 50 of the present embodiment is selectively provided with at least one pair of metal interconnects 21a and 21b on a tabular insulating base material 20. A diamond element is mounted on this insulating base material 20. In the diamond element, an insulating diamond layer 31 to act as a detection layer is deposited, and one pair of interdigitated electrodes 32a and 32b are deposited on the surface of this insulating diamond layer 31. The interdigitated electrodes 32a and 32b of the diamond element are electrically connected by wire bonding or the like to the metal interconnects 21a and 21b, respectively, deposited on the insulating base material 20.

In the diamond sensor 50 of the present embodiment, the measurement object radiation 1 is applied from the interdigitated electrodes 32a and 32b side.

The diamond element mounted on the diamond sensor 50 of the present embodiment is produced by forming the insulating diamond layer 31 on a substrate and, thereafter, removing the substrate. For example, in the case where a silicon substrate is used as the substrate of the diamond element, the substrate can readily be removed by using fluoro-nitric acid.

Furthermore, the measurement object radiation 1 can also be incident from the insulating base material side by forming the insulating base material 20 from a material which transmits the measurement object radiation 1. Fig. 6 is a side view schematically showing a diamond sensor of a modified example of the present embodiment. As shown in Fig. 6, the diamond sensor 51 of the present modified example is similar to the diamond sensor 50 of the above-described third embodiment except that the insulating base material 200 made of a material which transmits the measurement object radiation 1 is used in place of the insulating base material 20. In the diamond sensor 51 of the present modified example, although the sensitivity is lowered since electron-hole pairs are generated farther from the interdigitated electrodes 32a and 32b, radiation in a wider area can be collected since the electrode portions do not cast shadows by the incident light.

Since the diamond elements are provided with no substrate in the diamond sensor 50 of the third embodiment of the present invention and the diamond sensor 51 of the modified example thereof, low-profile diamond elements can be produced. The configuration other than those described above, the operation, and the effect of the diamond sensor 50 and the diamond sensor 51 are similar to those of the diamond sensor 10 of the above-described first embodiment.

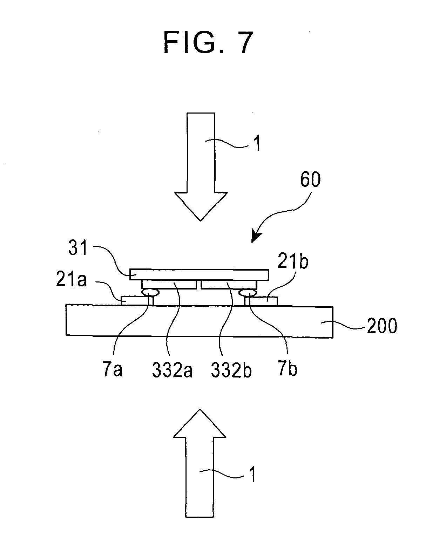

A diamond sensor according to the fourth embodiment of the present invention will be described below. Fig. 7 is a side view schematically showing a diamond sensor of the present embodiment. As shown in Fig. 7, the diamond sensor 60 of the present embodiment is selectively provided with metal interconnects 21a and 21b on an insulating base material 200 which transmits the measurement object radiation 1. In a diamond element, one pair of trapezoid electrodes 332a and 332b is deposited on the surface of an insulating diamond layer 31 to act as a detection layer. The diamond element is mounted on the insulating base material 200 such that the surface provided with the trapezoid electrodes 332a and 332b faces the insulating base material 200 side. In this diamond sensor 60, the trapezoid electrodes 332a and 333b are connected to the metal interconnects 21a and 21b, respectively, with gold bumps 7a and 7b or the like.

In the diamond sensor 60 of the present embodiment, it is preferable that a material for forming the insulating base material is a material, e.g., sapphire, capable of resisting chemical solutions. Consequently, the diamond element in the state in which the insulating diamond layer 31 is deposited on a silicon substrate is mounted on the insulating base material 200 and, thereafter, the silicon substrate is removed with fluoro-nitric acid or the like, so that a low-profile diamond sensor can be produced without damaging the diamond layer 31 having a reduced thickness.

In the diamond sensor 60 of the present embodiment, the measurement object radiation 1 can be applied from either the insulating diamond layer 31 side or the insulating base material 200 side. That the measurement object radiation 1 is incident from which side may be determined in consideration of the description in the above-described third embodiment. In the case where the measurement object radiation 1 is applied from the insulating diamond layer 31 side, the insulating base material may not transmit the measurement object radiation 1. The configuration other than those described above, the operation, and the effect of the diamond sensor of the present embodiment are similar to those of the diamond sensors of the above-described second and third embodiments.

### [Example 1]

The effect of Examples of the present invention will be described below in detail. In Example 1 of the present invention, a diamond sensor having a structure similar to that of the diamond sensor 10 of the first embodiment shown in Fig. 1 and Fig. 2 was prepared in a production procedure described below. A high-resistance silicon substrate having a surface composed of the (001) plane was used as the substrate 30. This high-resistance silicon substrate was exposed to mixed plasma of methane and hydrogen, so that the surface was carbonized. Subsequently, a bias was applied, so that diamond nuclei having an epitaxial relationship with the substrate was formed. Thereafter, the application of the bias was stopped, and a film formation of diamond was performed by using a mixed gas of methane and hydrogen for 15 hours on the condition in which the (100) plane was grown on a priority basis. In this manner, a highly-oriented diamond film of about 10 µm, in which the surface was composed of the (100) plane and crystal grains were oriented in a constant direction, was formed as the insulating diamond layer 31 on the substrate 30. The grain diameter of the (100) plane of this highly-oriented diamond film was 3 to 20 µm.

Carbon components other than diamond adhered to the surface were removed by cleaning with dichromic acid, and rinsing was performed with sulfuric acid, followed by cleaning with deionized water. Shapes of interdigitated electrodes were patterned on the highly-oriented diamond film by photolithography, platinum was sputtered by a magnetron sputtering method, and lift-off was performed, so that a pair of interdigitated electrodes 32a and 32b were formed.

A glass board (thickness:1 mm) was used as the insulating base material 20, and the metal interconnects 21a and 21b were formed thereon. Specifically, an aluminum film was formed all over the glass board by magnetron sputtering and, thereafter, a resist pattern was formed into the shapes of the metal interconnects 21a and 21b by photolithography. The aluminum film was etched by immersion in phosphoric acid and, thereafter, the resist was removed, so that the metal interconnects 21a and 21b having predetermined patterns were formed.

The silicon substrate was cut into the shape of a chip to cut out elements. Each of the resulting elements with the surface provided with the interdigitated electrodes 32a and 32b up was fixed on the insulating base material 20. The interdigitated electrodes 32a and 32b were wire-bonded to the metal interconnects 21a and 21b, respectively, with gold wires, so that the diamond sensor of Example 1 was prepared.

The diamond sensor of Example 1 produced by the above-described method was put in a measurement box protected from entrance of external light, a bias voltage was applied, and a dark current at that time was measured with a picoammeter. As a result, the dark current was 20 pA and, therefore, the leak current was at a satisfactorily low level in practice.

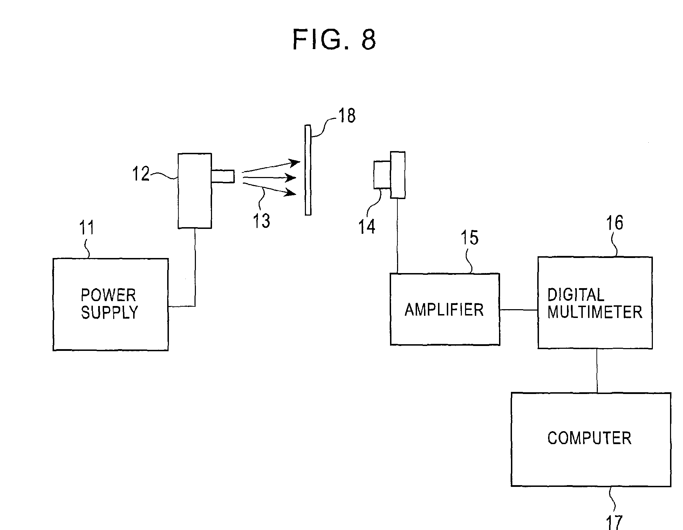

The response characteristic of the diamond sensor of Example 1 to the ultraviolet radiation was evaluated. Fig. 8 is a block diagram showing the evaluation method. A deuterium (L2D2) lamp (Type: L7293) produced by Hamamatsu Photonics K.K., was used as a radiation source 12, and M-4518 produced by Hamamatsu Photonics K.K., was used as a power supply 11 for the radiation source 12. As for the measurement, in the air, a bias voltage of 15 V was applied between two electrodes of each diamond sensor 14, a current originated from the application of light was amplified with an amplifier 15, and the resulting voltage value was measured with a digital multimeter 16. The value was taken into a computer 17. As for the evaluation, a shutter 18 was opened while the radiation intensity was kept constant, the diamond sensor 14 was irradiated with the ultraviolet radiation 13 for 300 minutes, and changes in the characteristic were measured. As a result, an output voltage in accordance with the intensity of radiation was attained and, therefore, it was ascertained that the sensor responded to the ultraviolet radiation.

### [Example 2]

In Example 2 of the present invention, a diamond sensor having a structure similar to that of the diamond sensor 60 of the fourth embodiment shown in Fig. 7 was prepared in a production procedure described below. A silicon substrate having a surface composed of the (001) plane was used as a substrate of a diamond element. This silicon substrate was exposed to mixed plasma of methane and hydrogen, so that the surface was carbonized. Subsequently, a bias was applied, so that diamond nuclei having an epitaxial relationship with the substrate 30 was formed. Thereafter, the application of the bias was stopped, and a film formation of diamond was performed by using a mixed gas of methane and hydrogen for 15 hours on the condition in which the (100) plane was grown on a priority basis. In this manner, a highly-oriented diamond film of about 10 µm, in which the surface was composed of the (100) plane and crystal grains were oriented in a constant direction, was formed as the insulating diamond layer 31 on the silicon substrate. The grain diameter of the (100) plane of this highly-oriented diamond film was 3 to 10 µm.

Carbon components other than diamond adhered to the surface were removed by cleaning with dichromic acid, and rinsing was performed with sulfuric acid, followed by cleaning with pure water. Shapes of the electrodes 332a and 332b in the shape of a trapezoid in a plan view were patterned on the highly-oriented diamond film by photolithography, platinum was sputtered on the highly-oriented diamond film by a magnetron sputtering method, and lift-off was performed, so that a pair of trapezoid electrodes 332a and 332b were formed.

A sapphire substrate (thickness:1 mm) was used as the insulating base material 200, and the metal interconnects 21a and 21b were formed thereon. Specifically, a resist pattern was selectively formed on portions other than the shapes of the metal interconnects 21a and 21b by photolithography. A platinum film was formed by a magnetron sputtering method. Thereafter, the resist pattern was removed and, in addition, unnecessary patterns were removed, so that the metal interconnects 21a and 21b in predetermined shapes were formed.

Gold bumps were formed at the portions of the metal interconnects 21a and 21b to be connected to the diamond element. The silicon substrate was cut into the shape of a chip to cut out elements. The surface of each of the resulting elements, the surface provided with the trapezoid electrodes 332a and 332b, was faced to the sapphire substrate side, the gold bumps 7a and 7b were aligned with the trapezoid electrodes 332a and 332b, and the diamond element was pressed against the sapphire substrate, so that the gold bumps 7a and 7b were connected to the trapezoid electrodes 332a and 332b, respectively. Subsequently, the silicon substrate was removed with fluoro-nitric acid by dissolution, so that the diamond sensor of Example 2 was prepared.

The diamond sensor of Example 2 produced by the above-described method was put in a measurement box protected from entrance of external light, a bias voltage was applied, and a dark current at that time was measured with a picoammeter. As a result, the dark current was 5 pA and, therefore, the leak current was at a satisfactorily low level in practice.

The response characteristic of the diamond sensor of Example 2 to the ultraviolet radiation was evaluated in a manner similar to that in the above-described Example 1. The ultraviolet radiation was incident from the sapphire substrate side, and it was ascertained that an output voltage in accordance with the intensity of radiation was attained. Since the sapphire substrate was able to interrupt the influence of generated ozone and the like, the response characteristic of the diamond sensor of Example 2 was further stable for a long time as compared with that of the diamond sensor of Example 1. The diamond sensor of Example 2 was able to exhibit sensitivity on the order of one-half the sensitivity of the diamond sensor of Example 1 on an electrode length basis and, therefore, practically satisfactory sensitivity was able to be achieved even by the irradiation through the sapphire substrate.

Furthermore, the operation was checked by the irradiation from the back. In this case, since the sensitivity became on the order of one-tenth the sensitivity of the diamond sensor of Example 1, the gain of the amplifier was adjusted such that a satisfactory output was able to be attained. In the present measurement example, the ultraviolet radiation was able to be measured at wide-ranging angles since the detection region was not obstructed by the metal electrodes.

### [Example 3]

In Example 3 of the present invention, a diamond sensor having a structure similar to that of the diamond sensor 50 of the third embodiment shown in Fig. 5 was prepared in a production procedure described below. A synthetic quartz board (thickness:1 mm) was used as an insulating base material 20. A concave portion 3 mm long, 3 mm wide, and 10 µm deep was formed beforehand at a position to be provided with the diamond element on the surface of this synthetic quartz board, and the diamond element provided with the insulating diamond layer formed from a polycrystalline diamond was deposited in this concave portion. The features of the present Example other than those described above were similar to those of the diamond sensor of the above-described Example 2. This diamond sensor was evaluated as in Example 2, and the operation similar to the diamond sensor of Example 2 was ascertained. With respect to the diamond sensor of the present Example, since the surface of the diamond layer and the surface of the insulating base material were arranged to become nearly flush with each other, the sensor was not damaged even when the measurement was repeated and, therefore, the durability was improved.

## Claims

1. A diamond sensor comprising:
an insulating base material having a thickness of not more than 3 mm;
at least one pair of metal interconnects selectively deposited on said insulating base material; and
a diamond element, said diamond element comprising a diamond layer to act as a detection layer and at least one pair of surface electrodes deposited on said diamond layer, wherein the surface electrodes in said pair are connected to their respective metal interconnects in said pair.

2. The diamond sensor according to Claim 1, further comprising an element substrate, wherein said diamond layer is deposited on said element substrate.

3. The diamond sensor according to Claim 2, wherein the thickness of said insulating base material is not more than 1 mm.

4. The diamond sensor according to Claim 2, wherein said diamond layer is a highly-oriented diamond layer in which the surface is composed of the (100) crystal plane, grown crystal grains are uniaxially oriented relative to said element substrate surface, and the crystal plane is also oriented in-plane.

5. The diamond sensor according to Claim 2, wherein said insulating base material transmits a measurement object radiation and said diamond layer faces said insulating base material.

6. The diamond sensor according to Claim 5, wherein the thickness of said insulating base material is not more than 1 mm.

7. The diamond sensor according to Claim 5, wherein said insulating base material is made of a material selected from the group consisting of synthetic quartz glass, sapphire, magnesium fluoride and calcium fluoride.

8. The diamond sensor according to Claim 5, wherein said diamond layer is a highly-oriented diamond layer in which the surface is composed of the (100) crystal plane, grown crystal grains are uniaxially oriented relative to said element substrate surface, and the crystal plane is also oriented in-plane.

9. The diamond sensor according to Claim 5, wherein said insulating base material transmits ultraviolet radiation with a wavelength of 172nm.

10. The diamond sensor according to Claim 1, wherein said diamond layer is provided directly on said insulating base material.

11. The diamond sensor according to Claim 10, wherein said diamond element is fabricated in a concave portion formed on the surface of said insulating base material so that the surface of said diamond element and the surface of said base material become flush with each other.

12. The diamond sensor according to Claim 10, wherein the thickness of said insulating base material is not more than 1 mm.

13. The diamond sensor according to Claim 10, wherein said insulating base material is made of a material selected from the group consisting of glass, synthetic quartz glass, sapphire, magnesium fluoride and calcium fluoride.

14. The diamond sensor according to Claim 10, wherein said diamond layer is a highly-oriented diamond layer in which the surface is composed of the (100) crystal plane, grown crystal grains are uniaxially oriented relative to the surface, and the crystal plane is also oriented in-plane.

15. The diamond sensor according to Claim 10, wherein said insulating base material transmits ultraviolet radiation with a wavelength of 172nm.

16. The diamond sensor according to Claim 1, wherein said surface electrodes face said insulating base material and said diamond layer is positioned on the outer side of said surface electrodes.

17. The diamond sensor according to Claim 16, wherein the thickness of said insulating base material is not more than 1 mm.

18. The diamond sensor according to Claim 16, wherein said insulating base material is made of a material selected from the group consisting of glass, synthetic quartz glass, sapphire, magnesium fluoride and calcium fluoride.

19. The diamond sensor according to Claim 16, wherein said diamond layer is a highly-oriented diamond layer in which the surface is composed of the (100) crystal plane, grown crystal grains are uniaxially oriented relative to the surface, and the crystal plane is also oriented in-plane.

20. The diamond sensor according to Claim 16, wherein said insulating base material transmits ultraviolet radiation with a wavelength of 172nm.
